# EUROPEAN PATENT APPLICATION

(11) **EP 1 089 318 A1**
(43) Date of publication of application: **04.04.2001**
(21) Application number: 99119443.2
(22) Date of filing: 30.09.1999
(51) Int. Cl.: H01J 37/32

(54) **Method for determining the endpoint of etch process steps**

(71) Applicant: Infineon Technologies AG, 81669 München (DE); Semiconductor 300 GmbH & Co. KG, 01074 Dresden (DE); MOTOROLA INC., Schaumburg, IL 60196-3750 (US)
(72) Inventor: Morgenstern, Thomas, 01109 Dresden (DE); Petrucci, Joseph Louis, 01277 Dresden (DE)
(74) Representative: Fischer, Volker, Dipl.-Ing.

(57) **Abstract**

The invention is directed to a method for determining the endpoint of etch process steps of wafers by way of an optical or interferometric endpoint determination system. According to the new method a measuring step is introduced to the wafer alignment step which determines the thickness of the PAD nitride on the top of the wafer. The film thickness data are added to the target of the endpoint algorithm and the etch step is stopped if the target depth plus the value of the measurement is reached.

## Description

### FIELD OF THE INVENTION

The invention is directed to a method for determining the endpoint of etch process steps e.g. during recess etch steps of wafers by way of an optical or interferometric endpoint determination system which is applied to a vacuum etch chamber within the etch steps are carried out.

### DESCRIPTION OF THE PRIOR ART

Several etch process steps such as the recess 2 and recess 3 steps are carried out within a vacuum chamber or a chamber with a low internal pressure. The vacuum chamber is normally provided with a plasma source for ionizing an etching gas which is introduced in the chamber. At front end of an etch step it is necessary to provide a wafer with an etch mask such as PAD nitride.

Many product types incorporate process steps which require blind etches which stop within a film layer, such processes include Recess Etches and Shallow Trench Isolation. The use of an endpoint measuring system has improved achieving the target depths. The chamber is further provided with a dome to separate the vacuum chamber from the environment. For this measuring system this dome has a window for determining the endpoint of the etching process at its top end. Such an endpoint determining system is an optical system which monitors the etch process and incorporates an interferometric measuring system which determines the depth of the etched recesses or trenches in a semiconductor wafer positioned in the chamber on the top of a base.

The target depths are referenced from the silicon surface which is usually below a masking layer (PAD nitride). The problem is that the masking layer can vary from lot to lot or from wafer to wafer. The problem regarding the endpoint determination system is therefore that Interferometric Endpoint measuring systems (IEP) are able to determine the depth of a hole or a trench but the depth which is determined is not the target depth. The measured depth is depending from the thickness of the masking layer on the top surface of the silicon. Therefore the depth of e.g. recess 2 and recess 3 varies depending from the thickness of the masking layer.

For this reason a film measurement step is required to obtain the necessary offset required to setup the IEP. This number is either the measurement of one wafer or the average of several wafers. The current endpoint systems allow for ony one input per lot.

### SUMMARY OF THE INVENTION

It is an object of the present invention to provide a method for determining the endpoint of an etch process step during recess etch steps which eliminates the influence of different thickness of the masking layer.

Another object of the present invention is to minimize the necessary tool adaption.

A further object of the present invention is to provide a method which can be used on all etches which must stop in the film being etched and not at an interface.

It is also an object of the invention to provide a method which is capable for 300 mm wafers and future embodiments.

In accordance with one object of the invention there is provided a method for determining the endpoint of etch process steps e.g. during recess etch steps of wafers by way of an optical endpoint determination system which is applied to a vacuum etch chamber within the etch steps are carried out after a wafer alignment, which is characterized in that a measuring step is introduced to the wafer alingment step which determines the thickness of the PAD nitride on the top of the wafer, that the measurement is forwarded to the endpoint determination system and added to the target of the endpoint algorithm and that the etch step is stopped if the target depth plus the value of the measurement is reached.

This new method eliminates the influences of different thickness of the masking layer and can be used on all etches which must stop in the film being etched and not at an interface. Also the necessary tool adaption is minimized.

The measuring step is carried out preferably with a laser measurement system which is based on ellipsometry.

To minimize the time for the measuring step this step is carried out with the laser measuring system which is preferably directed to the centre of the wafer.

The new method is capable for 300 mm wafers and future embodiements.

### BRIEF DESCRIPTION OF THE DRAWINGS

- Fig. 1: illustrates schematically the depth of an etched trench with the target depth and the IEP target; and
- Fig. 2: illustrates schematically the new method for determining the endpoint of etch steps e.g. during recess etch steps of wafers.

### DETAILED DESCRIPTION OF THE INVENTION

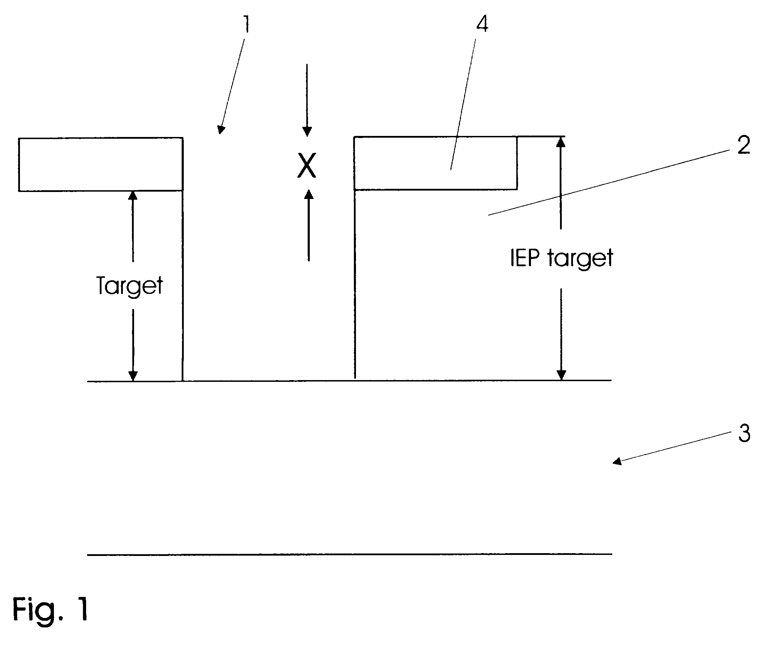

Figure 1 illustrates schematically the depth of an etched hole 1 e.g. a trench with the target depth within a poly Si layer 2. This target depth is the ideal depth which is necessary to built up a functional element within the wafer 3. To determine the endpoint of an etch process the mentioned Interferometric Endpoint measuring systems 6 are used. This IEP systems are able to determine the depth of a hole 1 or a trench but the depth that is determined is not the target depth. From Figure 1 it is to see that the determinable depth is a sum of the thickness x of the PAD nitride layer 4 and the target depth. If the thickness of the PAD nitride layer 4 is unknown then the measured depth at the endpoint is equal with the target depth and therefore the etched hole 1 or trench is not deep enough.

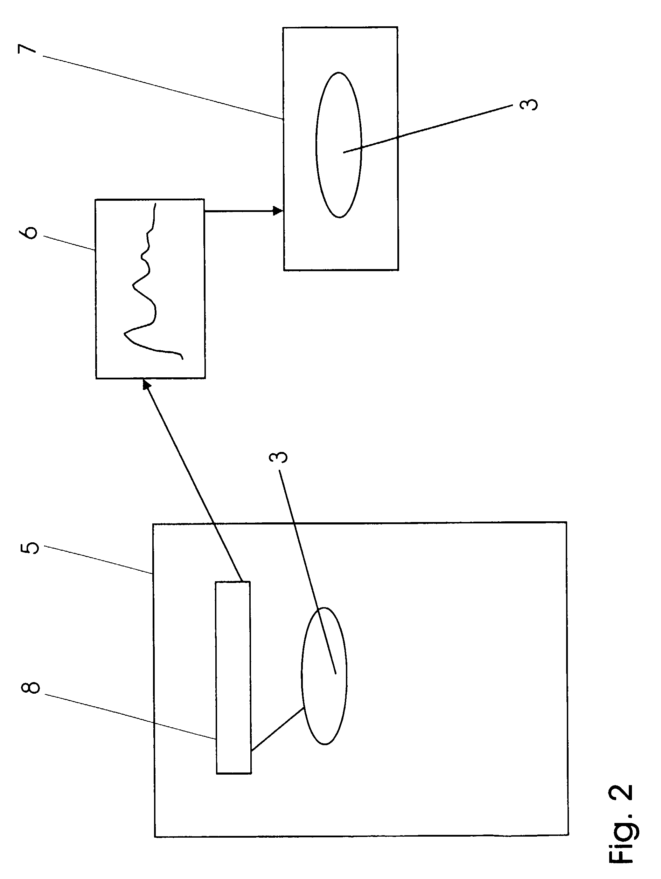

According to Figure 2 there is introduced an additional step which is carried out parallel to the alignment stage 5 in the front end of the etch process 7. This additional step covers a thickness measuring step to determine the thickness of the PAD nitride 4 of each wafer 3 introduced to the etch process 7.

This measuring step which is carried out preferably with a laser measurement system 8 which is based on ellipsometry determines the thickness of the PAD nitride 4 on the top of the wafer 3 first and then the measurement (film thickness data) is forwarded to the endpoint determination system. In this endpoint determination system (IEP) the measurement is added to the target of the endpoint algorithm. The current etch step is stopped if the target depth plus the value of the measurement is reached.

To minimize the time for the measuring step this step is carried out with the laser measuring system which is directed at the centre of the wafer 3.

The new method provides a wafer to wafer endpoint target determination through PAD-nitride thickness measurement in parallel to wafer alignment which eliminates the influences of different thickness of the masking layer and can be used on all etches which must stop in the film beeing etched and not at an interface.

## Claims

1. Method for determining the endpoint of etch process steps e.g. during recess etch steps of wafers by way of an optical or interferometric endpoint determination system which is applied to a vacuum etch chamber within the etch steps are carried out after a wafer alignment,
**characterized in** that a measuring step is introduced to the wafer alignment step which determines the thickness of the PAD nitride on the top of the wafer, that the measurement is forwarded to the endpoint determination system and added to the target of the endpoint algorithm and that the etch step is stopped if the target depth plus the value of the measurement is reached.

2. Method according to claim 1, **characterized in** that measuring step is carried out with a laser measurement system.

3. Method according to claim 2, **characterized in** that the laser measurement system is based on ellipsometry.

4. Method according to anyone of the claims 1 to 3, **characterized in** that measuring step is carried out with the laser measuring system which is directed at the centre of the wafer.
